# EUROPEAN PATENT SPECIFICATION

(11) **EP 0 933 778 B1**
(45) Date of publication and mention of the grant of the patent: **21.07.2004**
(21) Application number: 98121760.7
(22) Date of filing: 29.12.1992
(51) Int. Cl.: G11C 7/00

(54) **Nonvolatile semiconductor memory**
Nicht-flüchtiger Halbleiterspeicher
Mémoire à semiconducteur non volatile

(30) Priority: 03.12.1992 JP 32430292; 27.12.1991 JP 34666391
(43) Date of publication of application: 04.08.1999
(62) Divisional of application: 92311829.3
(73) Proprietor: FUJITSU LIMITED, Kawasaki-shi, Kanagawa 211-8588 (JP)
(72) Inventor: Kasa, Yasushi, c/o Fujitsu Ltd., Kawasaki-shi, Kanagawa 211-8588 (JP); Akaogi,Takao, c/o Fujitsu Ltd., Kawasaki-shi, Kanagawa 211-8588 (JP)
(74) Representative: Hitching, Peter Matthew

(56) References cited:
- US-A- 4 156 905
- US-A- 4 509 142

## Description

This invention relates to a nonvolatile semiconductor memory, particularly to an EPROM and an EEPROM including a nonvolatile memory circuit and, more particularly to a circuit construction of a nonvolatile semiconductor memory of the batch erasure type (hereinafter referred to as a flash memory).

The invention further relates particularly to a high speed reading operation in a nonvolatile semiconductor memory.

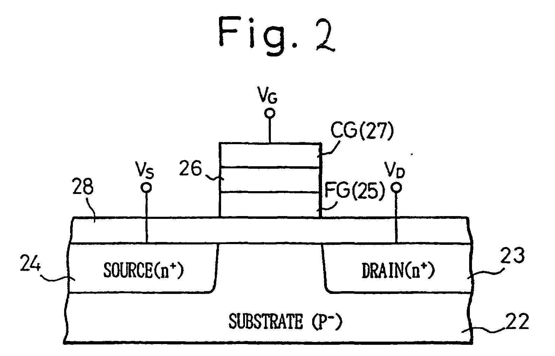

Fig. 2 of the accompanying drawings shows diagrammatically a structure of a cell used in a flash memory.

In this figure, indicated at V_{G} is a gate terminal, at V_{D} a drain terminal, at V_{S} a source terminal, at 27 a control gate CG connected to the gate terminal V_{G}, and at 25 a floating gate FG which is controlled by the potential of the control gate CG.

Further, indicated at 22 is a semiconductor substrate, e.g. a semiconductor substrate having P-type conductivity. On the semiconductor substrate 22 are mounted well portions 23, 24 made of semiconductor having N-type conductivity. The well portion 23 forms a drain while the well portion 24 forms a source. Indicated at 26, 28 are insulating films.

When data is read from the cell, 0V is applied to the source terminal V_{S}, a read voltage (normal supply voltage V_{CC}) of 5V is applied to the gate terminal V_{G}, and a voltage of about 1V is applied to the drain terminal V_{D}. Then, it is discriminated whether the read data is "1" or "0" depending upon whether a current flows through the cell. On the other hand, when data is written in the cell, 0V is applied to the source terminal V_{S}, a write/erase voltage V_{PP} of about 12V is applied to the gate terminal V_{G}, and a write drain voltage V_{W} (lower than V_{PP}) is applied to the drain terminal V_{D}. Thereby, electrons are injected into the floating gate FG from a drain region (writing operation). Further, when the data is erased, the drain terminal V_{D} is brought into an open state, and 0V and the write/erase voltage V_{PP} are applied to the gate terminal V_{G} and the source terminal V_{S} respectively. Thereby, the electrons are taken from the floating gate FG to a source region (erasing operation).

When the data is written, it is required to check whether the data is written sufficiently in the memory cell (write verification). Likewise, when the data is erased it is required to check whether the data is erased sufficiently from the memory cell (erase verification).

The write verification and erase verification are carried out so as to confirm whether the degree of writing and the degree of erasing have a sufficient margin for the read voltage, i.e., a variation range of the normal supply voltage V_{CC} (5V ± 0.5V). Generally, these verifications are carried out to confirm that an operation margin of about 0.5V to 1.0V is available for a voltage range of V_{CC}. In this case, the verify voltage including the operation margin is 6V to 6.5V in the write verification, and 3.5V to 4V in the erase verification.

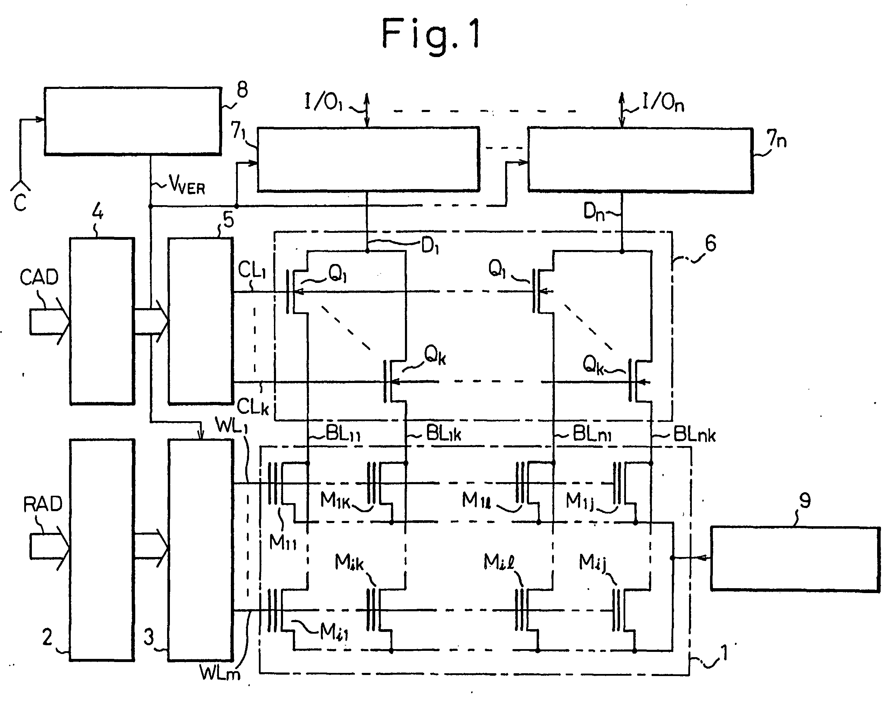

It is expected that the write verification and the erase verification can be accomplished easily if the verify voltage including the operation margin to be secured is applied to word lines (for example, word lines WL₁ to WLₘ of the f lash memory shown in Fig. 1), so that the sensitivity of the sense/amplify (S/A) circuit is the same regardless of whether the voltage V_{CC} or the verify voltage is applied as the supply voltage of the S/A circuit.

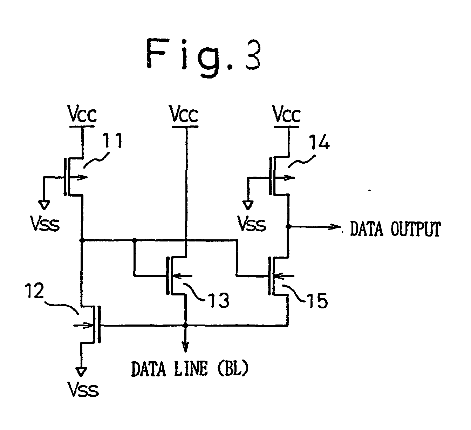

Fig. 3 of the accompanying drawings shows a construction of a general S/A circuit used in the non-volatile semiconductor memory such as an EPROM.

In this figure, indicated at V_{CC} is a line of a supply voltage 5V, and at V_{SS} a line of a supply voltage 0V. Between the power supply lines V_{CC} and V_{SS} are connected a p-channel transistor 11 and an n-channel transistor 12 in series. A gate of the transistor 11 is connected to power supply line V_{SS}, while a gate of the transistor 12 is connected to a data line (i.e., a bit line). Between the power supply line V_{CC} and the data line is connected an n-channel transistor 13 whose gate is connected to drains of the respective transistors 11, 12. Likewise, between the power supply line V_{CC} and the data line are connected a p-channel transistor 14 and an n-channel transistor 15 in series. A gate of the transistor 14 is connected to the power supply line V_{SS}, while a gate of the transistor 15 is connected to the drains of the respective transistors 11, 12. An output (data output) of the S/A circuit is taken from drains of the respective transistors 14, 15.

In this construction, when the data read from the memory cell is "1", i.e., when the level of the data line is "H", the transistor 12 is turned on and thereby a drain potential thereof is reduced to "L" level. Accordingly, the transistor 15 is cut off. Thus, the voltage of "H" level is output from the power supply line V_{CC} through the transistor 14 (data output). In other words, the data having the same level as the read data is sensed. Conversely, when the data read from the memory cell is "0", the transistor 12 is cut off and the voltage of "H" level is fed from the power supply line V_{CC} through the transistor 11 to the gate of the transistor 15 to turn the transistor 15 on. Thereupon, the level of a data output line is reduced to "L" (the data of "L" level is the same as the read data).

In this way, the transistor 15 is provided with a function of transmitting the level of the bit line to the data output line (bit line level adjustment), and the transistor 14 is provided with a function of discriminating the data of the memory cell according to the state (on/off) of the transistor 15.

In the non-volatile semiconductor memory of the prior art, in the case where a number of continuous addresses (greater than the number of built-in sense amplifiers per bit) are accessed, there exists halfway a waiting time for an operation of the sense amplifier. Thus, it is impossible to read an output of a corresponding data at regular time intervals and at a high speed.

United States patent number 4156905 discloses a volatile random access memory in which a prefetch register is used for receiving and temporarily storing a first address portion representing the location of a group of words to be stored in memory. The first address portion is utilized to access memory to retrieve a group of words to be stored in memory output registers, and a second address portion is utilized to select words contained in the output registers. When a subsequent group of words is to be accessed, a second first address portion is loaded into the prefetch register and the first address portion of the current requested address is compared with the presently used first address portion; a miscomparison generates a miscompare signal which clocks a new group of words into the output registers of the memory and simultaneously transfers the first address portion in the prefetch register to a present fetch register. words are then retrieved from memory through the decoding of the second address portion to access words stored in the output registers. In the memory of US 4156905, specific prefetch addressing means are necessary for providing the prefetch address.

United States patent number 4509142 discloses a memory device containing a self-incrementing counter. The memory cell array may be accessed using either an incoming address or the last address incremented by one. The preamble of claim 1 is based on this disclosure.

According to the present invention there is provided a semiconductor memory as indicated in claim 1.

Reference will now be made, by way of example, to the accompanying drawings, in which:
Fig. 1 is an overall construction diagram showing an example of a flash memory to which an embodiment of the invention can be applied;
Fig. 2 is a diagram showing a cell structure for explaining an operation of the flash memory;
Fig. 3 is a circuit diagram showing a construction of the S/A circuit as an example of the prior art;
Fig. 4 is a block diagram showing parts of a semiconductor memory of the prior art;
Fig. 5 is a timing chart for use in explaining operation of the Figure 4 semiconductor memory;
Fig. 6 is a block diagram showing parts of a semiconductor memory embodying the present invention;
Fig. 7 is a timing chart for use in explaining operation of the Figure 6 semiconductor memory;
Fig. 8 is a block diagram showing an operation procedure of the semiconductor memory embodying the present invention; and
Figs. 9 to 14 are block diagrams showing the operation procedure of the semiconductor memory embodying the present invention.

Fig. 1 is a block diagram showing parts of a flash type memory.

In this figure, indicated at 1 is a cell array formed by arranging erasable nonvolatile memory cells Mᵢⱼ at intersections of a plurality of word lines WL₁ to WLₘ and a plurality of bit lines BL₁₁ to BL₁ₖ, ... , BLₙ₁ to BLₙₖ. In this embodiment, the cell array is divided into n blocks, in each of which (k × m) memory cells are arranged. Indicated at 2 is a row address buffer for buffering a row address RAD of an address signal fed externally thereto, at 3 a row decoder for decoding the row address and selecting any one of the word lines WL₁ to WLₘ, at 4 a column address buffer for buffering a column address CAD of the address signal, and at 5 a column decoder for decoding the column address and selecting any one of column lines CL₁ to CLₖ corresponding to the bit lines BLi₁ to BLiₖ for each of the aforementioned blocks. Indicated at 6 is a column gate circuit including transfer gate transistors Q₁ to Qₖ corresponding to the bit lines BLᵢ₁ to BLᵢₖ for each of the aforementioned blocks. The respective transistors Q₁ to Qₖ are turned on when the corresponding column lines CL₁ to CLₖ are selected, to thereby connect the selected bit line BLᵢⱼ to a data line Dᵢ.

Indicated at 7₁ to 7ₙ are respectively writing circuits and S/A circuits for applying amplification to a write data and sense amplification to a read data between corresponding internal data lines D₁ to Dₙ and external input/output data lines I/O₁ to I/Oₙ. Indicated at 8 is a verify source voltage generating circuit for generating a verify voltage V_{VER} in accordance with a control signal C fed externally thereto. The generated verify source voltage V_{VER} is supplied to the selected word lines WL₁ to WLₘ through the row decoder 3 as described later, and to the S/A circuit corresponding to the selected word line. Indicated at 9 is a source voltage supply circuit for supplying a source voltage in common to the respective sources of the nonvolatile memory cells Mᵢⱼ.

Incidentally, when predetermined data is read out from the nonvolatile memory device described above, the device may employ a method which includes a plurality of sense amplifiers per bit and selects the output of the sense amplifiers by the address so that the data of a plurality of addresses can be read out in parallel with one another.

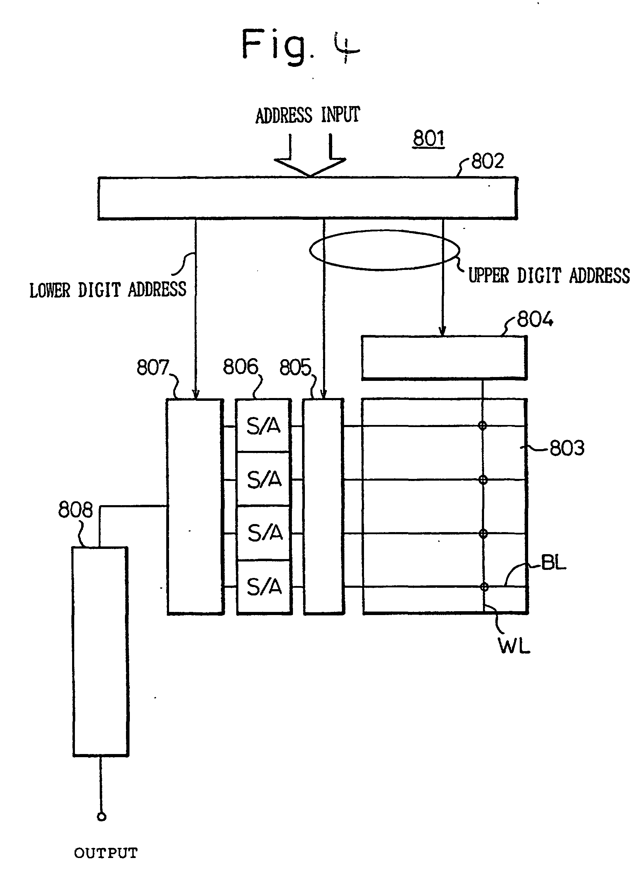

Fig. 4 shows parts of a semiconductor memory device 801 according to the prior art.

This device has an address buffer 802 for receiving an address input ADD inputted from a suitable external memory circuit, bit selection means 805, a sense amplifier 806, sense amplifier selection means 807 and an output buffer 808. The address buffer means 802 is provided with first address generation means for simultaneously making access to a predetermined number of data groups and reading them, and with second address generation means for individually selecting a plurality of data selected by the first address generation means. The first address generation means selects, for example, a predetermined word line from a plurality of word lines WL, and makes it possible to read out all of a plurality of data stored along the selected word line. The addressing information generated by the first address generation means is generally referred to as a "high order address".

On the other hand, the second address generation means generates addresses for suitably and individually selecting the bit lines BL in order to select a plurality of data selected by the host address. These addresses are generally referred to as a "lower order address".

In the conventional semiconductor memory device 801 having such a construction, the read-out operation of the data by the first address generation means, that is, by the higher order address, is time-consuming, while the read-out operation of the selected data for each bit line BL by the second address generation means, that is, by the lower order address, can be executed within an extremely short time.

In other words, in the conventional semiconductor memory device, selection of data by the higher order address is time-consuming, while selection of data by the lower order address under the state where the higher order address is fixed, that is, under the state where the higher order address does not change, can be carried out at random and at high speed. However, when the higher order address is again selected, the access time becomes longer.

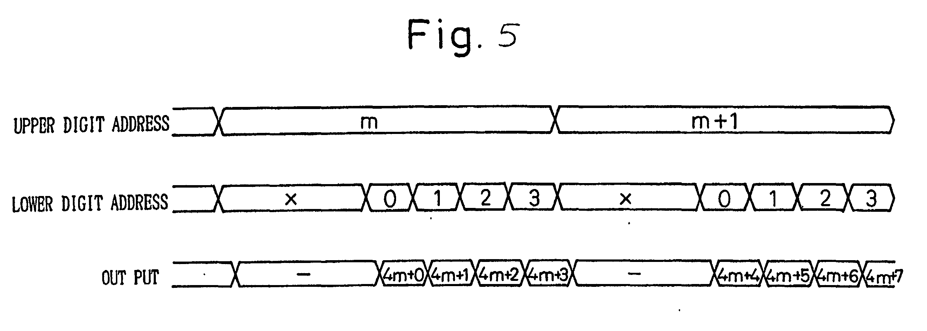

Therefore, referring to the timing chart of Fig. 5 according to the prior art, when the higher order address reads out the data (0, 1, 2, 3) of the address m in the course of a predetermined time and then writes the data into the sense amplifier 806 or the like, a period in which no operation is carried out, is deliberately set as a sense wait time such as the period represented by symbol X. After this wait time has elapsed, the data (0, 1, 2, 3) is then written into each sense amplifier 806 and is thereafter output sequentially from the output buffer 808 by the sense amplifier selection means 807.

In other words, since a sense wait time exists in the conventional semiconductor memory device 801, the data read-out time is time-consuming. Therefore, the conventional semiconductor memory device is not suitable for high speed operation.

Particularly when the number of continuous adresses to be accessed in greater than the number of sense amplifiers provided per bit in the semiconductor memory device 801, the wait time for the operation of the sense amplifiers exists in the interim. Thus, there is another problem that the data output cannot be read out in a uniform time interval and at a high speed.

Therefore, an embodiment of the present invention seeks to provide a non-volatile semiconductor memory device which can eliminate the drawbacks of the prior art described above, and which can read out a plurality of data stored in memory cell means at a high speed.

To accomplish the object described above, an embodiment of the present invention employs the following technical construction.

In a semiconductor memory device including at least address buffer means, memory cell means, word line selection means, bit line selection means, output buffer, first address generation means for imparting one address to each group using a plurality of data as one group, and second address generation means for imparting one address to each of the individual data, the semiconductor memory device according to this embodiment further includes first readout means for selecting and reading out one of a plurality of data groups through the word line selection means or the bit line selection means by the use of one address value in the first address generation means, second readout means for selectively reading out the individual data constituting the data group selected and read out from a plurality of data groups by one address of the first address generation means, by the use of the address value in the second address generation means, and precedence readout means for reading out a plurality of other data groups corresponding to other addresses of the first address generation means by the values of other addresses in the first address generation means, after a predetermined number of data are read out by one address of the first address generation means but before each of a plurality of data read out by one address of the first address generation means is selectively read out to the output buffer by the respective address in the second address generation means.

A non-volatile semiconductor memory device embodying the present invention employs the basic technical construction described above. In contrast, the prior art employs a construction wherein, when the access is made to the memory cell means by the use of the higher order address to once output predetermined data to the output buffer and then makes once again the access to the memory cell means by the use of the next or other higher order address, the prior art makes the access to the memory cell means by the use of the higher order address to read out the predetermined data, and while the data is once written and stored in the sense amplifier, the prior art sets the sense wait time described above so that no operation is carried out in that period. However, an embodiment of the present invention utilizes this sense wait time for making access to the memory cell means in advance by the use of the next or other higher order address so as to read out the data corresponding to the address and to prepare for the next operation.

In other words, in a semiconductor memory device embodying the present invention, the readout operation by the higher order address, which will otherwise need a long time, can be executed in advance, so as to improve the read-out speed of the data.

A semiconductor memory according to this embodiment of the present invention will be explained in detail with reference to the drawings.

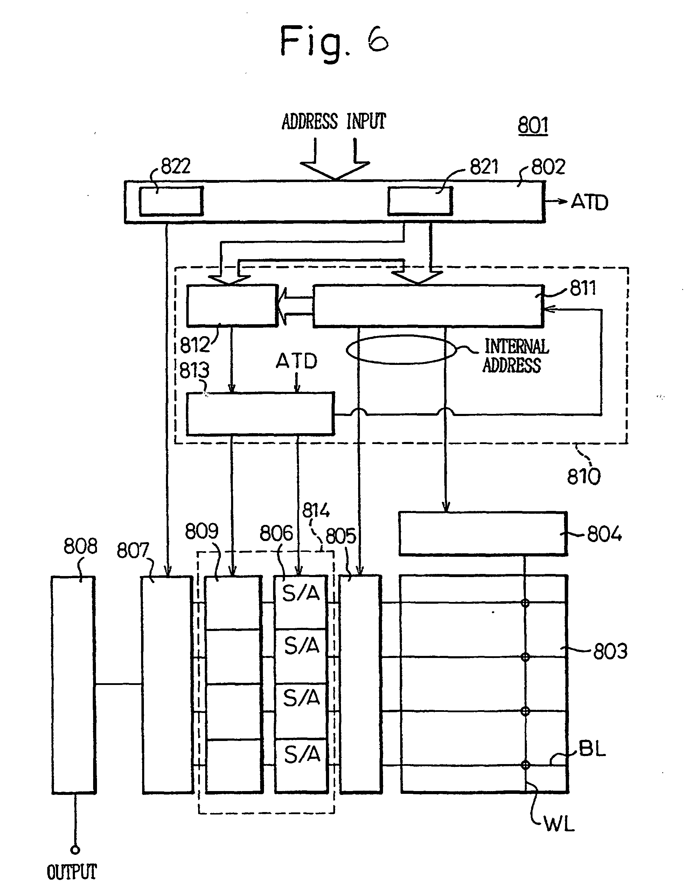

Figure 6 is a block diagram showing the semiconductor memory 801 according to the embodiment. The semiconductor memory 801 comprises address buffer means 802, memory cell means 803, word line selection means 804, bit line selection means 805, and an output buffer 808. The address buffer means 802 includes a first address generator 821 for generating an address to specify a group of data pieces, and a second address generator 822 for generating addresses to specify the data pieces within a specified group.

The semiconductor memory 801 further comprises first read means 814 for selecting and reading a group of data pieces through the word line selection means 804 or the bit line selection means 805 according to an address provided by the first address generator 821; second read means 807 for selecting the data pieces, which have been selected and read according to the address provided by the first address generator 821 through the word line selection means 804 or the bit line selection means 805, according to addresses provided by the second address generator 822 and providing the output buffer 808 with the data pieces as selected (the second read means 807 may be sense amplifier selection means 807); and pre-read means 810 for reading another group of data pieces according to another address provided by the first address generator 821 while the preceding data pieces, which have been read according to the address provided by the first address generator 821, are being selected and provided to the output buffer 808 according to the addresses provided by the second address generator 822.

The semiconductor memory 801 of this embodiment basically resembles the conventional semiconductor memory 801 of Fig. 4. The semiconductor memory 801 of this embodiment is characterized by the pre-read means 810, which reads, during a sense wait time, a group of data pieces from the memory cell means 803 according to the next or another upper address and has the read data pieces on standby.

The first address generator 821 in the embodiment generates an address for specifying, for example, a word line WL and bit lines BL corresponding to a group of different data pieces. Namely, the address provided by the first address generator 821 corresponds to a conventional upper address.

The second address generator 822 in this embodiment generates addresses for selecting a data piece from amongst the group of data pieces selected by the first address generator 821. Each sense amplifier of the first read means outputs a data piece of the group and the output data output from the sense amplifier is selected by the sense amplifier selecting means 807. Namely, the address provided by the second address generator 822 correspond to conventional lower addresses.

The first read means 814 may comprise sense amplifiers 806, or the sense amplifiers 806 and latch circuits 809.

The pre-read means 810 in this embodiment includes an internal address generator 811 and a comparator 812. The internal address generator 811 has an input portion for receiving an address from the first address generator 821 of the address buffer means 802, and means such as a counter for changing an address held in the internal address generator 811 according to a given control signal. The comparator 812 compares an address provided by the internal address generator 811 with an address provided by the first address generator 821.

When the two addresses agree with each other, the comparator 812 provides a signal according to which the first read means 814 pre-reads a group of data pieces corresponding to the agreed address out of the memory cell means 803. At the same time, the comparator 812 provides the internal address generator 811 with a control signal. In response to the control signal, the internal address generator 811 changes a count of the counter (the address changing means), to provide a different address.

This different address may be an increment or decrement of the preceding address, or a random address.

The pre-read means 810 in this embodiment has a timing controller 813 for controlling the internal address generator 811 and comparator 812 in relation to one another.

The timing controller 813 also controls the timing of the sense amplifiers 806 and latch circuits 809 of the first read means 814 as well as the timing of the sense amplifier selection means (the second read means) 807.

The timing controller 813 is controlled by an address transition detector (not shown) that determines whether or not an address from the first address generator 821 has been changed and,when it has been changed, provides a signal ATD.

Reading a group of data pieces according to an address provided by the internal address generator 811 from the memory cell means 803 into the sense amplifiers 806 of the first read means 814 involves a predetermined delay time. The pre-read means 810 uses this delay time, to access, in advance, an address that is different from the address now provided by the internal address generator 811.

After the delay time, the timing controller 813 provides a latch signal. In response to the latch signal, the latch circuits 809 latch the data pieces from the sense amplifiers 806. At the same time, the timing controller 813 provides a signal for changing a count in the internal address generator 811.

In this way, this embodiment accesses the next upper address while the present data are being read and delivered to the outside, to thereby solve the problems of the prior art. To achieve this, the embodiment employs the detector for detecting a change in an address provided by the first address generator 821, the counter (or an adder) 817 for incrementing an address according to an addition signal generated when the address change is detected, the comparator 812 for comparing the incremented address with an externally provided address, the latch circuits 809 for latching data pieces from the sense amplifiers 806, and the timing controller 813 for generating control signals for controlling the above-mentioned circuits according to predetermined timing. When the first address generator 821 provides a different address, the comparator 812 compares this address with an incremented address provided by the internal address generator 811. If the addresses agree with each other, the latches 809 latch data from the sense amplifiers 806, and the latched data are delivered to the outside.

Thereafter, the address in the internal address generator 811 is incremented to start the next access operation. This process is repeated to access continuous or random addresses at high speed.

Irrespective of the number of addresses that are simultaneously accessed in the semiconductor memory, this embodiment can read data from consecutive addresses at high speed. The embodiment requires a small number of sense amplifiers in a chip, to thereby reduce the chip area and cost per bit.

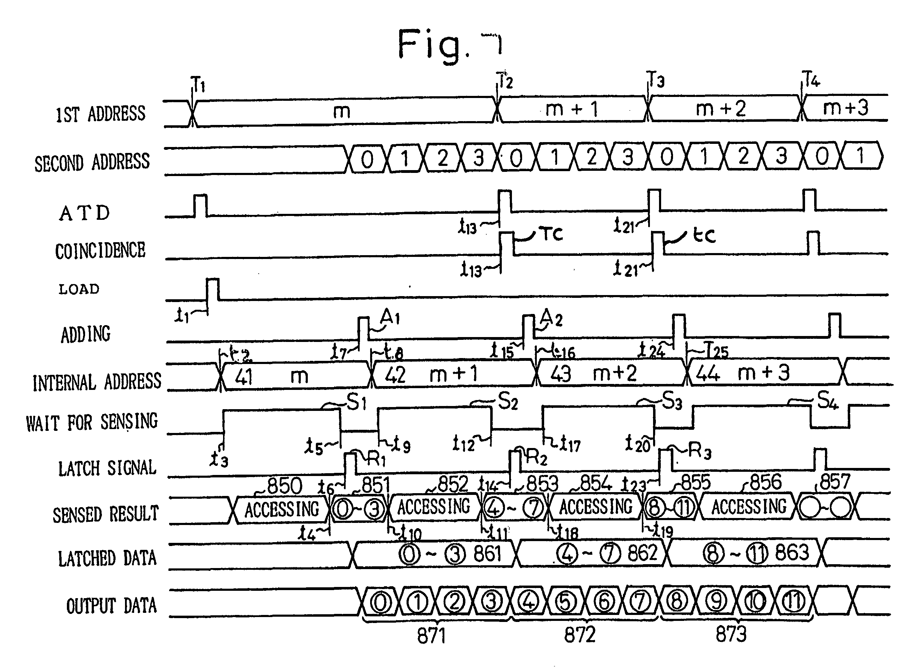

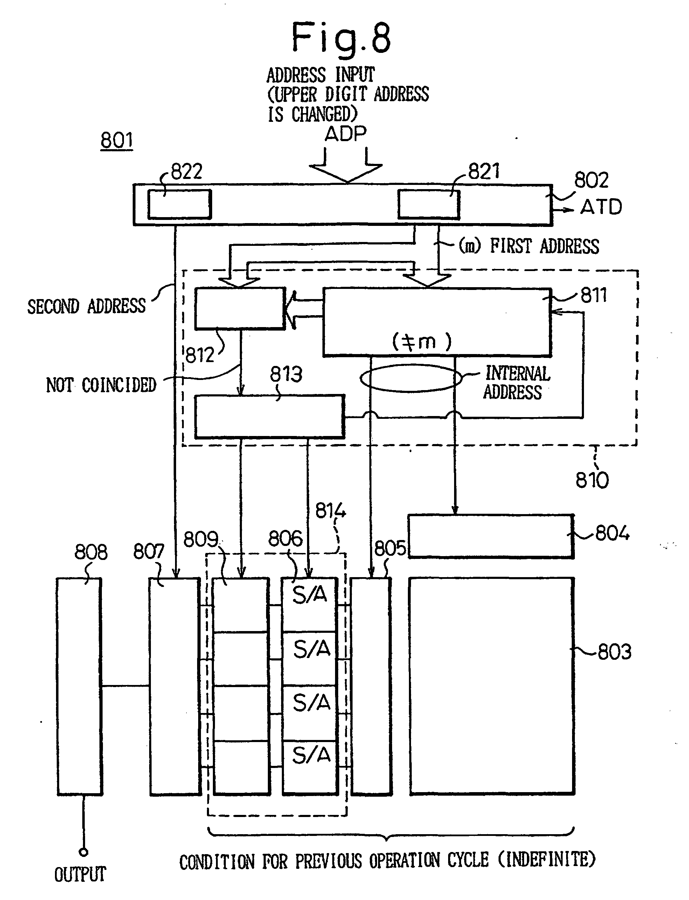

Operations of the semiconductor memory 801 will be explained with reference to a timing chart of Fig. 7 and operational views of Figs. 8 to 14.

Figure 8 shows an initial state of the semiconductor memory 801. The first address generator 821 provides the comparator 812 and internal address generator 811 with an address m.

The comparator 812 receives no internal address from the internal address generator 811, and therefore provides a disagreement signal.

In Fig. 8, the comparator 812 has just provided the disagreement signal ("not coincident").

On the timing chart in Fig. 7, the first address generator 821 provides the address m at time T1. At the same time, an address change detected signal ATD is provided to drive the comparator 812. A signal LOAD is provided at time t1 as there is no coincidence. Accordingly, at time t2, the external adress m from the first address generator 821 is provided to and held by the internal address generator 811, as indicated with numeral 41.

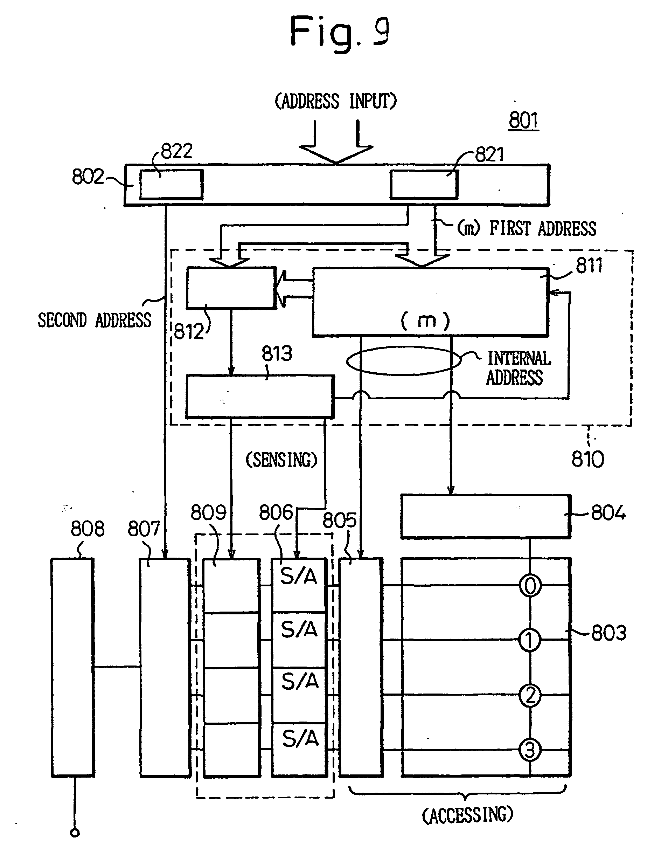

In Fig. 9, a word line m is selected according to the address m, and data pieces 0 to 3 corresponding to the word line m are read.

A sense wait time S1 starts at time t3. During the sense wait time S1, the processing of the data pieces 0 to 3 of the address m is suspended.

An access period 850 is of the preceding step. In this example, nothing is done during the access period 850 because the process has just started.

Just before the end of the sense wait time S1, a period 851 starts at time t4. During the period 851, the sense amplifiers 806 read the data pieces 0 to 3 from the address m. When the sense wait time S1 ends at time t5, a latch signal R1 is provided at time t6, so that the latches 809 latch the data pieces 0 to 3 from the sense amplifiers 806 during a period 861.

The signals LOAD and ATD, signals for the sense wait time S, and latch signal are provided through the timing controller 813.

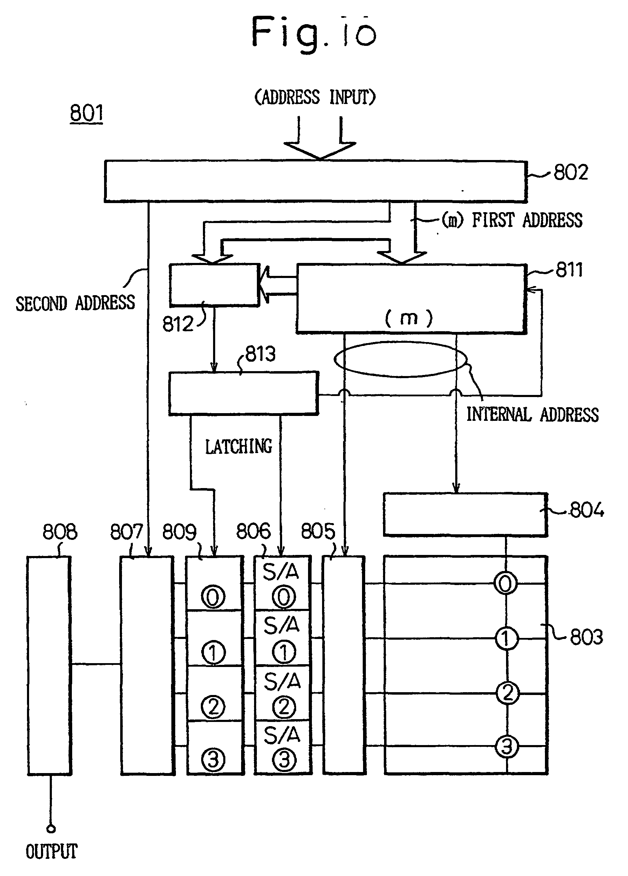

Results of these processes are shown in Fig. 10.

In response to the latch signal R1, an addition signal A1 is provided at time t7. As a result, the address m in the internal address generator 811 is incremented, for example, by one to m+1, which is held therein during a period 42 starting at time t8.

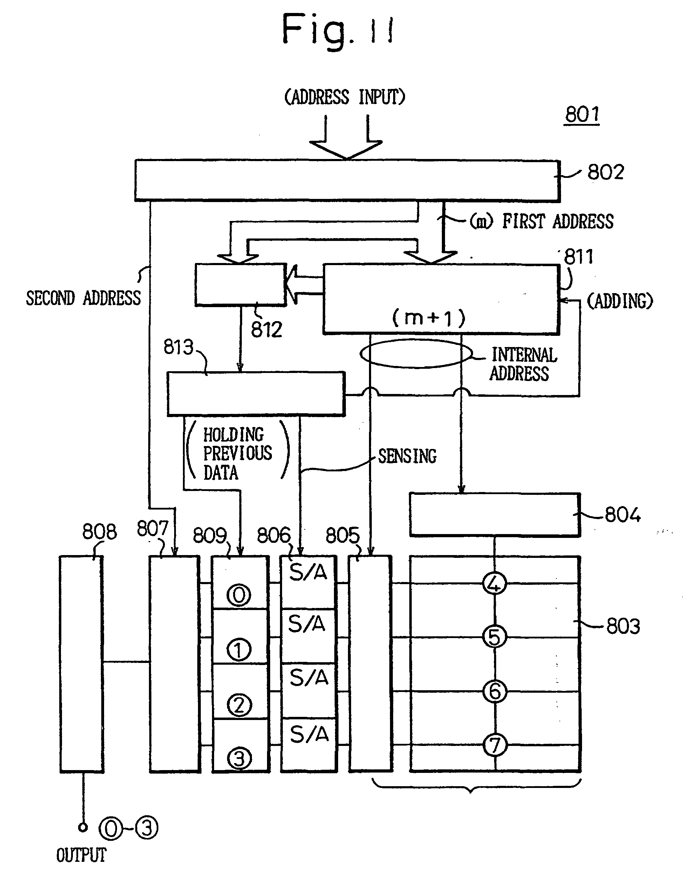

In Fig. 11, a word line m+1 is selected according to the address m+1, and data pieces 4 to 7 corresponding to the word line m+1 are read.

Meanwhile, during a period 871, the data pieces 0 to 3 latched by the latch circuits 809 are provided to the output buffer 808 through the sense amplifier selection means 807 sequentially or at random according to addresses provided by the second address generator 822.

Results of these operations are shown in Fig. 11.

At time t9, another sense wait time S2 starts. During a period 852 between t10 and t11 within the wait time S2, the memory cell means 803 is accessed according to the address m+1 provided by the internal address generator 811, to read the data pieces 4 to 7.

During a period 853 starting at t11, the sense amplifiers 806 read the data pieces 4 to 7 from the address m+1.

The sense wait time S2 ends at time t12. At time T2 the external address provided by the first address generator 821 becomes m+1. The address change detector accordingly provides the address change signal ATD at time t13. In response to the signal ATD, the comparator 812 carries out comparison.

The comparator 812 determines that the address m+1 provided by the internal address generator 811 agrees with the external address m+1 provided by the first address generator 821, and provides an agreement signal IC.

In response to the signal IC, a latch signal R2 is provided at time t14, so that the latch circuits 809 latch the data pieces 4 to 7 from the sense amplifiers 806 during a period 862.

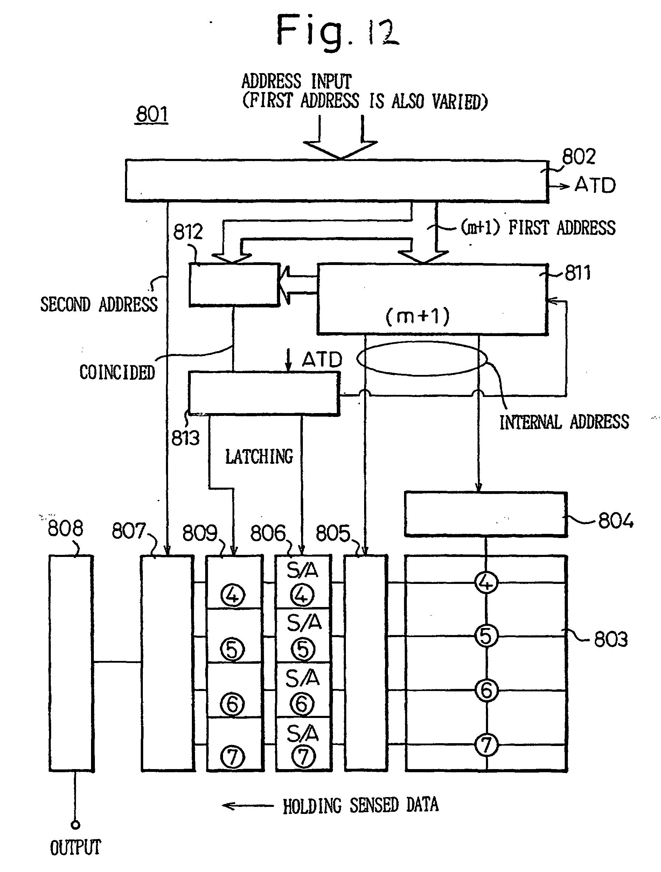

Results of these operations are shown in Fig. 12.

In response to the latch signal R2, an addition signal A2 is provided at time t15. Accordingly, the internal address generator 811 increments the currently-held address m+1 by one to m+2 and holds it during a period 43 starting from time t16.

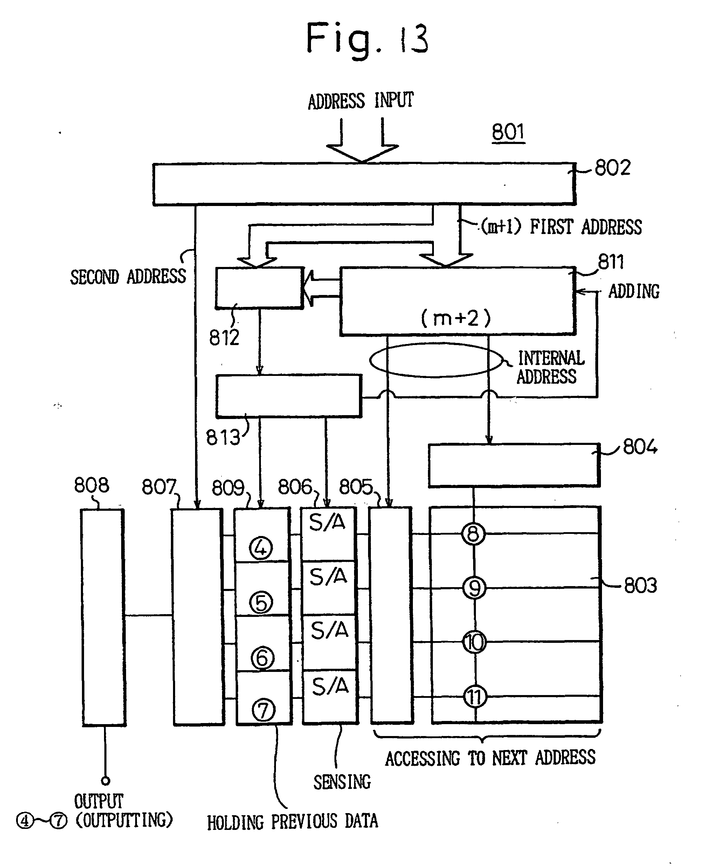

In Fig. 13, a word line m+2 is selected according to the address m+2, and data pieces 8 to 11 corresponding to the word line m+2 are read.

Namely, the internal address generator 811 starts a pre-read access to the word line m+2.

Meanwhile, during a period 872, the data pieces 3 to 7 latched by the latch circuits 809 are provided to the output buffer 808 through the sense amplifier selection means 807 sequentially or at random according to addresses provided by the second address generator 822.

At time t17, another sense wait time S3 starts. During a period 854 between t18 and t19 within the wait time S3, the memory cell means 803 is accessed according to the address m+2 provided by the internal address generator 811, to read the data pieces 8 to 11.

During a period 855 starting at t19, the sense amplifiers 806 read the data pieces 8 to 11 from the address m+2.

The sense wait time S3 ends at time t20. The external address provided by the first address generator 821 becomes m+2 at time T3. Accordingly, the address change detector provides an address change signal ATD at time t21. In response to the signal ATD, the comparator carries out comparison.

The comparator 812 determines that the address m+2 provided by the internal address generator 811 agrees with the external address m+2 provided by the first address generator 821, and provides an agreement signal IC.

In response to the signal IC, a latch signal R3 is provided at time t23, so that the latch circuits 809 latch the data pieces 8 to 11 from the sense amplifiers 806 during a period 863.

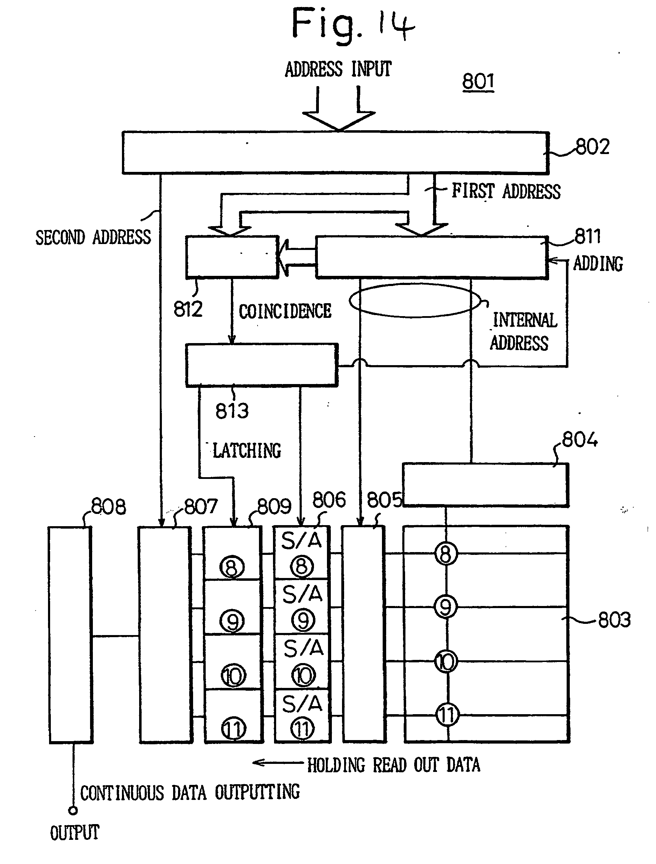

Results of these operations are shown in Fig. 14.

In response to the latch signal R3, an addition signal A3 is provided at time t24. Accordingly, the internal address generator 811 increments the presently held address m+2 by one to m+3 and holds it during a period 44 starting at time t25. Similar to the previous case, the internal address generator 811 starts a pre-read access with the address m+3, to read data pieces 12 to 15 from a word line m+3.

Meanwhile, during a period 873, the data pieces 8 to 11 latched by the latch circuits 809 are provided to the output buffer 808 through the sense amplifier selection means 807 sequentially or at random according to addresses provided by the second address generator 822.

The above processes are repeated.

As explained above, this embodiment uses a sense wait time to pre-read memory cell means according to the next or another upper address and has data pieces corresponding to the address on standby.

Since an access to the memory cell means according to an upper address takes a relatively long time, the pre-reading operation of the embodiment may be effective to improve a data read speed.

Irrespective of the number of addresses to be simultaneously read in a semiconductor memory, the embodiment can read consecutive addresses at high speed. The embodiment requires a small number of sense amplifiers in a chip, to thereby reduce a chip area and cost per bit.

## Claims

1. A semiconductor memory comprising:
memory cell means arranged in groups of memory cells, each memory cell being addressable by a word line and a bit line;
word line selection means (804);
bit line selection means (805);
address generation means (821, 822) for generating an address for selecting a data item in said memory cell means (803);
read means (814, 807) for reading a data item from the memory cell means (803) according to an address provided by the address generation means (821, 822); and
pre-read means (810) comprising an input portion for receiving an address from the address generation means (821), internal address generation means (811) for changing an address held therein in response to a predetermined control signal and comparison means (812) for comparing an address provided by the internal address generation means (811) with an address provided by said address generating means (821,822) and for causing, if the compared addresses agree with each other, said read means to read another data item from the memory cell means via said bit line selection means;
**characterised in that**:
the memory is non-volatile;
said address generation means comprises first address generation means (821) for generating an address for reading a group of data items from the memory cell means, and second address generation means (822) for generating an address for selecting a data item from amongst a group of data items which has been read from the memory cell means;
said read means comprises first read means (814) for reading a group of data items from the memory cell means (803) according to an address provided by the first address generation means (821), and second read means (807) for selecting, according to an address provided by the second address generation means (822), a data item from amongst the group of data items which has been read from the memory cell means according to the address provided by the first address generation means;
said pre-read means (810) is arranged to read another group of data items from the memory cell means according to another address to be provided by the first address generation means (821) while the preceding data items are being selected by the second read means according to the address provided by the second address generation means;
the internal address generation means (811) is for selecting said another group of data items in said memory cell means; and
said comparison means (812) comparing an address provided by the internal address generation means (811) with an address provided by the first address generation means (821), and providing, if the compared addresses agree with each other, a signal in response to which the first read means (814) reads said another group of data items from the memory cell means (803) via said bit line selection means (805).

2. A semiconductor memory according to claim 1 further comprising timing control means (813) for relationally controlling the internal address generation means and comparison means.

3. A semiconductor memory according to claim 1 or 2, wherein the comparison means (812) generates, if the compared addresses agree with each other, a predetermined control signal in response to which the internal address generation means (811) changes the address held therein.

4. A semiconductor memory device according to any of the preceding claims wherein the internal address generation means (811) has a counter as means for changing the address held therein.

5. A semiconductor memory according to any of the preceding claims wherein the first read means comprises sense amplifiers, or sense amplifiers and latch circuits.

6. A semiconductor memory according to claim 5 wherein the second read means comprises sense amplifier selection means.

7. A semiconductor memory according to claim 5 or 6, wherein the pre-read means is arranged to access a different address during a predetermined delay time in which a group of data items are read by the sense amplifiers of the first read means according to an address provided by the internal address generation means.

8. A semiconductor memory according to claim 7 wherein, when the predetermined delay time elapses, the timing control means provides a latch signal according to which the latch circuits latch the data pieces from the sense amplifiers, and a count in the internal address generation circuit is changed.

9. A semiconductor memory according to any of the preceding claims, further comprising address buffer means (802) connected to the first address generation means (821), and an output buffer (808) to which data items are selectively provided by the second read means, (807).

## Patentansprüche

1. Halbleiterspeicher, mit:
einem Speicherzellenmittel, das in Gruppen von Speicherzellen angeordnet ist, wobei jede Speicherzelle durch eine Wortleitung und eine Bitleitung adressierbar ist;
einem Wortleitungs-Auswahlmittel (804);
einem Bitleitungs-Auswahlmittel (805);
einem Adreßerzeugungsmittel (821, 822), um eine Adresse zum Auswählen eines Datenelements im Speicherzellenmittel (803) zu erzeugen;
einem Lesemittel (814, 807), um ein Datenelement aus dem Speicherzellenmittet (803) gemäß einer Adresse zu lesen, die durch das Adreßerzeugungsmittel (821, 822) geliefert wird; und
einem Vor-Lesemittel (810) mit einem Eingabeteil, um eine Adresse vom Adreßerzeugungsmittel (821) zu empfangen, einem Interne-Adresse-Erzeugungsmittel (811), um eine darin gehaltene Adresse als Antwort auf ein vorbestimmtes Steuersignal zu ändern, und einem Vergleichsmittel (812), um eine durch das Interne-Adresse-Erzeugungsmittel (811) gelieferte Adresse mit einer durch das Adreßerzeugungsmittel (821, 822) gelieferten Adresse zu vergleichen und, falls die verglichenen Adressen miteinander übereinstimmen, zu veranlassen, daß das Lesemittel über das Bitleitungs-Auswahlmittel ein anderes Datenelement aus dem Speicherzellenmittel liest;
**dadurch gekennzeichnet, daß**:
der Speicher nicht flüchtig ist;
das Adreßerzeugungsmittel ein erstes Adreßerzeugungsmittel (821) zum Erzeugen einer Adresse, um eine Gruppe von Datenelementen aus dem Speicherzellenmittel zu lesen, und ein zweites Adreßerzeugungsmittel (822) zum Erzeugen einer Adresse aufweist, um ein Datenelement aus einer Gruppe von Datenelementen auszuwählen, die aus dem Speicherzellenmittel ausgelesen wurde;
das Lesemittel ein erstes Lesemittel (814) zum Lesen einer Gruppe von Datenelementen aus dem Speicherzellenmittel (803) gemäß einer durch das erste Adreßerzeugungsmittel (821) gelieferten Adresse und ein zweites Lesemittel (807) aufweist, um gemäß einer durch das zweite Adreßerzeugungsmittel (822) gelieferten Adresse ein Datenelement aus der Gruppe von Datenelementen auszuwählen, die gemäß der durch das erste Adreßerzeugungsmittel gelieferten Adresse aus dem Speicherzellenmittel gelesen wurde;
das Vor-Lesemittel (810) dafür eingerichtet ist, eine andere Gruppe von Datenelementen aus dem Speicherzellenmittel gemäß einer anderen Adresse zu lesen, die durch das erste Adreßerzeugungsmittel (821) geliefert werden soll, während die vorhergehenden Datenelemente gerade durch das zweite Lesemittel gemäß der durch das zweite Adreßerzeugungsmittel gelieferten Adresse ausgewählt werden;
das Interne-Adresse-Erzeugungsmittel (811) zum Auswählen der anderen Gruppe von Datenelementen in dem Speicherzellenmittel dient; und
das Vergleichsmittel (812) eine durch das Interne-Adresse-Erzeugungsmittel (811) gelieferte Adresse mit einer durch das erste Adreßerzeugungsmittel (821) gelieferten Adresse vergleicht und, falls die verglichenen Adressen miteinander übereinstimmen, ein Signal liefert, auf das als Antwort das erste Lesemittel (814) die andere Gruppe von Datenelementen über das Bitleitungs-Auswahlmittel (805) aus dem Speicherzellenmittel (803) liest.

2. Halbleiterspeicher nach Anspruch 1, ferner mit einem Zeitlagensteuermittel (813), um die Beziehung zwischen dem Interne-Adresse-Erzeugungsmittel und dem Vergleichsmittel zu steuern.

3. Halbleiterspeicher nach Anspruch 1 oder 2, worin das Vergleichsmittel (812), falls die verglichenen Adressen miteinander übereinstimmen, ein vorbestimmtes Steuersignal erzeugt, auf das als Antwort das Interne-Adresse-Erzeugungsmittel (811) die darin gehaltene Adresse ändert.

4. Halbleiterspeichervorrichtung nach einem der vorhergehenden Ansprüche, worin das Interne-Adresse-Erzeugungsmittel (811) einen Zähler als Mittel zum Ändern der darin gehaltenen Adresse hat.

5. Halbleiterspeicher nach einem der vorhergehenden Ansprüche, worin das erste Lesemittel Leseverstärker oder Leseverstärker und Latch-Schaltungen umfasst.

6. Halbleiterspeicher nach Anspruch 5, worin das zweite Lesemittel Leseverstärker-Auswahlmittel aufweist.

7. Halbleiterspeicher nach Anspruch 5 oder 6, worin das Vor-Lesemittel dafür eingerichtet ist, auf eine verschiedene Adresse während einer vorbestimmten Verzögerungszeit zuzugreifen, in der eine Gruppe von Datenelementen durch die Leseverstärker des ersten Lesemittels gemäß einer durch das Interne-Adresse-Erzeugungsmittel gelieferten Adresse gelesen wird.

8. Halbleiterspeicher nach Anspruch 7, worin, wenn die vorbestimmte Verzögerungszeit verstreicht, das Zeitlagensteuermittel ein Latch-Signal liefert, gemäß dem die Latch-Schaltungen Datenstücke von den Leseverstärkern zwischenspeichem und eine Zählung in der Interne-Adresse-Erzeugungsschaltung geändert wird.

9. Halbleiterspeicher nach einem der vorhergehenden Ansprüche, ferner mit einem Adreßpuffermittel (802), das mit dem ersten Adreßerzeugungsmittel (821) verbunden ist, und einem Ausgabepuffer (808), an den durch das zweite Lesemittel (807) selektiv Datenelemente geliefert werden.

## Revendications

1. Une mémoire à semiconducteur comprenant :
une structure de cellules de mémoire arrangée en groupes de cellules de mémoire, chaque cellule de mémoire pouvant être adressée par un conducteur de mot et un conducteur de bit;
des moyens de sélection de conducteur de mot (804);
des moyens de sélection de conducteur de bit (805);
des moyens de génération d'adresse (821, 822) pour générer une adresse pour sélectionner un élément de données dans la structure de cellules de mémoire (803);
des moyens de lecture (814, 807) pour lire un élément de données dans la structure de cellules de mémoire (803) conformément à une adresse fournie par les moyens de génération d'adresse (821, 822); et
des moyens de pré-lecture (810) comprenant une partie d'entrée pour recevoir une adresse provenant des moyens de génération d'adresse (821), des moyens de génération d'adresse interne (811) pour changer une adresse conservée à l'intérieur, en réponse à un signal de commande prédéterminé, et des moyens de comparaison (812) pour comparer une adresse fournie par les moyens de génération d'adresse interne (811) avec une adresse fournie par les moyens de génération d'adresse (821, 822) et pour faire en sorte que, si les adresses comparées concordent mutuellement, les moyens de lecture lisent un autre élément de données dans la structure de cellules de mémoire, par l'intermédiaire des moyens de sélection de conducteur de bit;
**caractérisée en ce que** :
la mémoire est non volatile;
les moyens de génération d'adresse comprennent des premiers moyens de génération d'adresse (821) pour générer une adresse pour lire un groupe d'éléments de données dans la structure de cellules de mémoire, et des seconds moyens de génération d'adresse (822) pour générer une adresse pour sélectionner un élément de données parmi un groupe d'éléments de données qui a été lu dans la structure de cellules de mémoire;
les moyens de lecture comprennent des premiers moyens de lecture (814) pour lire un groupe d'éléments de données dans la structure de cellules de mémoire (803) conformément à une adresse fournie par les premiers moyens de génération d'adresse (821), et des seconds moyens de lecture (807) pour sélectionner, conformément à une adresse fournie par les seconds moyens de génération d'adresse (822), un élément de données parmi le groupe d'éléments de données qui a été lu dans la structure de cellules de mémoire, conformément à l'adresse fournie par les premiers moyens de génération d'adresse;
les moyens de pré-lecture (810) sont adaptés pour lire un autre groupe d'éléments de données dans la structure de cellules de mémoire, conformément à une autre adresse devant être fournie par les premiers moyens de génération d'adresse (821) pendant que les éléments de données précédents sont sélectionnés par les seconds moyens de lecture, conformément à l'adresse fournie par les seconds moyens de génération d'adresse;
les moyens de génération d'adresse interne (811) sont destinés à sélectionner ledit autre groupe d'éléments de données dans la structure de cellules de mémoire; et
les moyens de comparaison (812) comparent une adresse fournie par les moyens de génération d'adresse interne (811) avec une adresse fournie par les premiers moyens de génération d'adresse (821), et fournissent, si les adresses comparées concordent mutuellement, un signal en réponse auquel les premiers moyens de lecture (814) lisent ledit autre groupe d'éléments de données dans la structure de cellules de mémoire (803), par l'intermédiaire du moyen de sélection de conducteur de bit (805).

2. Une mémoire à semiconducteur selon la revendication 1, comprenant en outre des moyens de commande temporelle (813) pour commander, en relation, les moyens de génération d'adresse interne et les moyens de comparaison.

3. Une mémoire à semiconducteur selon la revendication 1 ou 2, dans laquelle si les adresses comparées concordent mutuellement, les moyens de comparaison (812) génèrent un signal de commande prédéterminé en réponse auquel les moyens de génération d'adresse interne (811) changent l'adresse conservée à l'intérieur.

4. Un dispositif de mémoire à semiconducteur selon l'une quelconque des revendications précédentes, dans lequel les moyens de génération d'adresse interne (811) ont un compteur en tant que moyens pour changer l'adresse conservée à l'intérieur.

5. Une mémoire à semiconducteur selon l'une quelconque des revendications précédentes, dans laquelle les premiers moyens de lecture comprennent des amplificateurs de lecture, ou des amplificateurs de lecture et des circuits de bascules.

6. Une mémoire à semiconducteur selon la revendication 5, dans laquelle les seconds moyens de lecture comprennent des moyens de sélection d'amplificateur de lecture.

7. Une mémoire à semiconducteur selon la revendication 5 ou 6, dans laquelle les moyens de pré-lecture sont adaptés pour accéder à une adresse différente pendant un temps de retard prédéterminé au cours duquel un groupe d'éléments de données sont lus par les amplificateurs de lecture des premiers moyens de lecture, conformément à une adresse fournie par les moyens de génération d'adresse interne.

8. Une mémoire à semiconducteur selon la revendication 7, dans laquelle, lorsque le temps de retard prédéterminé s'est écoulé, les moyens de commande temporelle produisent un signal de mémorisation conformément auquel les circuits de bascules mémorisent les éléments de données provenant des amplificateurs de lecture, et une valeur de comptage dans le circuit de génération d'adresse interne est changée.

9. Une mémoire à semiconducteur selon l'une quelconque des revendications précédentes, comprenant en outre des moyens tampons d'adresse (802) connectés aux premiers moyens de génération d'adresse (821), et un tampon de sortie (808) auquel des éléments de données sont fournis sélectivement par les seconds moyens de lecture (807).
